## Europäisches Patentamt

## European Patent Office

## Office européen des brevets

(11) Veröffentlichungsnummer: **0 131 951**
**A1**

(12) **EUROPÄISCHE PATENTANMELDUNG**

(21) Anmeldenummer: **84108361.1**

(22) Anmeldetag: **16.07.84**

(51) Int. Cl.⁴: **H 03 K 19/094**

(30) Priorität: **18.07.83 DE 3325830**

(43) Veröffentlichungstag der Anmeldung:
**23.01.85 Patentblatt 85/4**

(84) Benannte Vertragsstaaten:
**AT BE CH DE FR GB IT LI NL**

(71) Anmelder: **Siemens Aktiengesellschaft**
**Berlin und München Wittelsbacherplatz 2**
**D-8000 München 2(DE)**

(72) Erfinder: **Wiedeburg, Klaus Hanno, Dr.-Ing.**
**Veilchenstrasse 7**
**D-8039 Puchheim(DE)**

(54) **Logik-Schaltungsanordnung in GaAs-MESFET-Technik.**

(57) Zur Verbindung einer in BFL-Technik realisierten Logik-Schaltung mit einer in SDFL-Technik realisierten Logik-Schaltung ist dem Ausgang der BFL-Logik-Schaltung ein einfacher BFL-Negator-Zweig I nachgeschaltet, dessen Ausgang direkt mit dem Eingang eines SDFL-Negators II verbunden ist, der dem Eingang der übrigen SDFL-Logik-Schaltung vorgeschaltet ist. Der SDFL-Negator II kann auch durch einen Eingangsweig einer SDFL-Verknüpfungsschaltung für mehr als eine Eingangsvariable gebildet sein.

FIG 3

EP 0 131 951 A1

SIEMENS AKTIENGESELLSCHAFT
Berlin und München

0131951

Unser Zeichen
VPA 83 P 1490 E

## Logik-Schaltungsanordnung in GaAs-MESFET-Technik

Neuere Entwicklungen der Halbleiter-Technik haben zu integrierten Logik-Schaltungen mit GaAs-Metall-Halbleiter-
Feldeffekttransistoren, sog. MESFETs, geführt, wobei man
heute im Prinzip vier GaAs-MESFET-Schaltungstechniken
unterscheidet (IEEE Journal of Solid-State Circuits
Vol. SC-17, No. 3, June 1982, S.569...584, 573), nämlich
   1) die sog. BFL(Buffered FET Logic)-Technik,
   2) die sog. SDFL(Schottky Diode FET Logic)-Technik,
   3) die sog. DCFL(Direct Coupled FET Logic)-Technik, und
   4) die sog. LPFL(Low Pinchoff-Voltage FET Logic)-Technik.

Die letzteren beiden GaAs-MESFET-Schaltungstechniken sehen
im Prinzip, Anreicherungs-(Enhancement-)Transistoren vor, d.h. ohne
Gatespannung nichtleitende Transistoren, bei denen die
Kanalbildung durch eine Gatespannung bewirkt wird;
die ersteren beiden GaAs-MESFET-Schaltungstechniken sehen
Verarmungs-(Depletion-)Transistoren vor, d.h. aufgrund entsprechender Dotierung der Kanalzone ohne Gatespannung
leitende Transistoren, die durch eine Gatespannung gesperrt
werden. Verarmungstyp-Logikschaltungen, die eine zusätzliche Speisespannung zur Erzeugung der erforderlichen
Sperrspannung benötigen, zeigen im Prinzip einen zweistufigen
Aufbau ihrer Verknüpfungsglieder; so besteht jedes BFL-
Verknüpfungsglied aus dem eigentlichen Logik-Zweig und
einem nachfolgenden Buffer-Zweig.
Jede Schaltungstechnik hat gewisse Vorteile: So erreicht
man mit der BFL-Technik sehr hohe Schaltgeschwindigkeiten
bei allerdings relativ hohen Verlustleistungen; mit
der SDFL-Technik gelangt man zu demgegenüber geringeren

27.6.83 / Spr 1 Kel

Verlustleistungen. Logik-Schaltungen dieser beiden
Schaltungstechniken sind bisher nur auf getrennten
Bausteinen realisiert werden. Es hat sich indessen
als wünschenswert erwiesen, auf ein und demselben
Baustein auch Schaltungen beider Schaltungstechniken
realisieren zu können, und die Erfindung zeigt hierzu
einen Weg.

Die Erfindung betrifft eine Logik-Schaltungsanordnung
in GaAs-MESFET-Technik; diese Schaltungsanordnung ist
erfindungsgemäß dadurch gekennzeichnet, daß zur Verbindung einer in BFL-Technik realisierten, ein oder
mehrere durch jeweils einen BFL-Logik-Zweig und einen
nachfolgenden BFL-Buffer-Zweig gebildete BFL-Verknüpfungsglieder aufweisenden GaAs-MESFET-Logik-
Schaltung mit einer in SDFL-Technik realisierten
GaAs-MESFET-Logik-Schaltung dem durch den Ausgang
des Buffer-Zweigs eines BFL-Verknüpfungsgliedes
gebildeten Ausgang der übrigen BFL-Logik-Schaltung ein
BFL-Logik-Zweig, insbesondere ein BFL-Negator-Zweig,
nachgeschaltet ist, dessen Ausgang direkt mit dem
Eingang eines SDFL-Verknüpfungsgliedes, insbesondere
eines SDFL-Negators, verbunden ist, das dem Eingang der
übrigen SDFL-Logik-Schaltung vorgeschaltet ist. In
weiterer Ausgestaltung der Erfindung kann dabei der
genannte SDFL-Inverter auch durch einen Eingangszweig
einer SDFL-Verknüpfungsschaltung für mehr als eine
Eingangsvariable gebildet sein.

Die Erfindung bringt den Vorteil mit sich, einen direkten
Übergang von in BFL-Technik gehaltenen Schaltungsteilen
zu in SDFL-Technik gehaltenen Schaltungsteilen auf ein
und demselben IC-Baustein vornehmen zu können, so daß
z.B. schnelle Eingangsstufen oder z.B. Zähler in
(mit höheren Verlustleistungen verbundener) BFL-Technik realisiert werden können und nachfolgende, ggf. auch
langsamere, Schaltungsteile in (mit niedrigeren Verlustleistungen verbundener) SDFL-Technik. Die Erfindung ermöglicht es dabei indessen nicht nur, beispielsweise
bereits in BFL-Technik erstellte Zellendesigns mit SDFL-
Blöcken auf ein und demselben Chipbaustein zu kombinieren,
sondern eröffnet darüber hinaus auch die Möglichkeit,
bereits in BFL-Technik erstellte Zellendesigns in der
Chip-Peripherie entsprechend zu ergänzen, so daß der
an sich in BFL-Technik realisierte Chip-Baustein auch in
einer SDFL-Umgebung eingesetzt werden kann.

Anhand der Zeichnungen sei die Erfindung noch näher
erläutert. Dabei verdeutlicht
Fig.1 den prinzipiellen Aufbau eines in BFL-Technik
realisierten Verknüpfungsgliedes;
Fig.2 läßt den prinzipiellen Aufbau eines in SDFL-Technik
realisierten Verknüpfungsgliedes erkennen.
Fig.3 zeigt ein Ausführungsbeispiel einer Logik-Schaltungsanordnung gemäß der Erfindung.

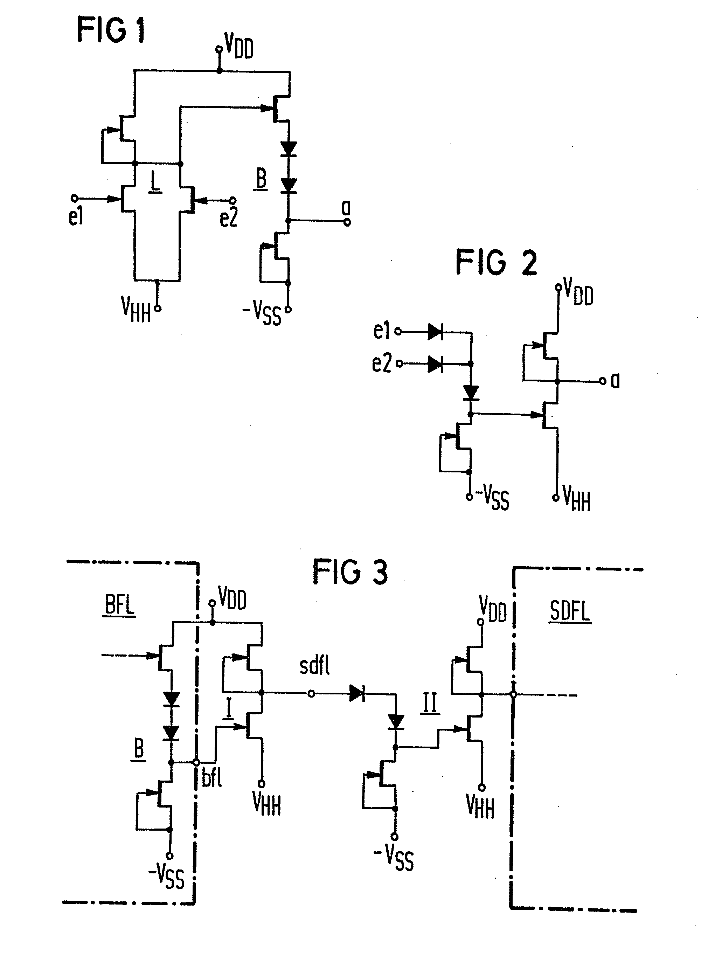

Die Zeichnung Fig.1 zeigt zur Verdeutlichung der bekannten
BLF-Technik ein in dieser Technik ausgeführtes NOR-Glied
für zwei Eingangsvariable. Dieses NOR-Glied besteht aus
zwei Zweigen, dem mit zwei an ihren Steuerelektroden jeweils
von einer Eingangsvariablen beaufschlagten, mit ihren
Hauptelektroden einander parallel geschalteten MESFET-
Eingangstransistoren und einem gemeinsamen MESFET-Lasttransistor aufgebauten eigentlichen Logik-Zweig und dem
nachfolgenden, durch die Serienschaltung eines MESFET-
Lasttransistors, zweier Dioden und eines vom Logik-
Zweig L gesteuerten weiteren, als Source-Folger geschalteten
MESFET-Transistors gebildeten Buffer-Zweig B. Der Buffer-
Zweig B liegt dabei zwischen einer Source-Speisespannung
$-V_{SS}$ und einer Drain-Speisespannung $V_{DD}$, an der auch der Logik-Zweig L liegt; die Source-Elektroden der beiden
Eingangstransistoren des Logik-Zweiges L liegen an einer
Hilfsspannung $V_{HH}$, die auch durch Massepotential gegeben
sein kann.

Nur wenn an beiden Eingängen e1 und e2 des NOR-Gliedes
gemäß Fig.1 eine dem Wert O der Schaltvariablen entsprechende Sperrspannung (Low-Pegel) anliegt, ist der vom Logik-
Zweig L gesteuerte Transistor des Buffer-Zweiges B so gut leitend, daß am Ausgang a des NOR-Gliedes gemäß Fig.1 die
dem Wert 1 der Schaltvariablen entsprechende Ausgangsspannung (High-Pegel) auftritt.

Die Zeichnung Fig.2 zeigt demgegenüber ein in der
ebenfalls bekannten SDFL-Technik ausgeführtes NOR-Glied
für zwei Eingangsvariable. Dieses NOR-Glied weist zwei
von den zwei Eingangsvariablen beaufschlagte OR-Verknüpfungs-Dioden auf, die über eine nachfolgende gemeinsame Pegelverschiebungs-Diode und einen MESFET-Lasttransistor an der Source-Speisespannung $-V_{SS}$ liegen;
an den Verbindungspunkt von Pegelverschiebungs-Diode
und Lasttransistor ist die Gate-Elektrode eines einerseits mit seiner Source-Elektrode an der Hilfsspannung
$V_{HH}$ und andererseits mit seiner Drain-Elektrode über
einen MESFET-Lasttransistor an der Drain-Speisespannung
$V_{DD}$ liegenden weiteren MESFET-Transistors angeschlossen.

Wie man erkennt, tritt am Ausgang a des NOR-Gliedes gemäß
Fig.2 eine dem Wert 1 der Schaltvariablen entsprechende
Ausgangsspannung (High-Pegel) nur dann auf, wenn an beiden
Eingängen e1 und e2 eine dem Wert O der Schaltvariablen
entsprechende Sperrspannung (Low-Pegel) anliegt.

Nachdem Low- bzw. High-Pegel einer BLF-Logik-Schaltung
einerseits und einer SDLF-Logik-Schaltung andererseits
nicht miteinander übereinstimmen, kann eine SDLF-Logik-
Schaltung nicht unmittelbar an eine BLF-Logik-Schaltung
angeschlossen werden. Wie dennoch eine Verbindung einer

in SDFL-Technik realisierten GaAs-MESFET-Logik-Schaltung
mit einer in BFL-Technik realisierten, eine oder mehrere
durch jeweils einen BFL-Logik-Zweig und einen nachfolgenden BFL-Buffer-Zweig gebildete BFL-Verknüpfungsschaltungen
aufweisenden GaAs-MESFET-Logik-Schaltung realisiert werden
kann, zeigt Fig.3.

Gemäß Fig.3 ist ein durch einen BFL-Negator I gebildeter
BFL-Logik-Zweig dem durch den Ausgang des Buffer-Zweigs B
(vgl. Fig.1) eines BFL-Verknüpfungsgliedes gebildeten
Ausgang bfl der übrigen, in Fig.3 nicht näher dargestellten BFL-Logik-Schaltung BFL nachgeschaltet.
Der Ausgang des BFL-Logik-Zweiges I, an dem nun (bei
entsprechenden Pinch-Off-Spannungen) gerade die für die
SDFL-Technik charakteristischen Signalpegel auftreten,
ist direkt mit dem Eingang sdfl eines durch einen SDFL-
Negator II gebildeten SDFL-Verknüpfungsgliedes verbunden,
das dem Eingang der übrigen, in Fig.3 wiederum nicht näher
dargestellten SDFL-Logik-Schaltung SDFL vorgeschaltet ist.
Über die beiden Negatoren I und II können nun BFL-Logik-
Schaltung und SDFL-Logik-Schaltung miteinander zusammenarbeiten, was hier indessen nicht weiter betrachtet zu
werden braucht, da dies zum Verständnis der Erfindung
nicht mehr erforderlich ist.

Es sei besonders bemerkt, daß das gemäß Fig.3 durch
den SDFL-Negator II gebildete SDFL-Verknüpfungsglied
in Abweichung von der in Fig.3 gegebenen Darstellung
auch durch einen Eingangszweig eines SDFL-Verknüpfungsgliedes für mehr als eine Eingangsvariable gebildet,
d.h. Bestandteil eines im Rahmen einer SDFL-Logik-
Schaltung ohnehin vorgesehenen SDFL-Verknüpfungsgliedes
sein kann.
In entsprechender Weise kann auch der dem Ausgangs-
Buffer-Zweig B der BFL-Logik-Schaltung nachgeschaltete,
gemäß Fig.3 durch den BFL-Negator I gebildete BFL-
Logik-Zweig in Abweichung von der in Fig.3 gegebenen Darstellung auch durch einen BFL-Logik-Zweig für
mehrere, im Rahmen einer BFL-Logik-Schaltung ohnehin
zu verknüpfende Eingangsvariable gebildet sein.

Patentansprüche

1. Logik-Schaltungsanordnung in GaAs-MESFET-Technik,
dadurch gekennzeichnet, daß zur Verbindung einer in
BFL-Technik realisierten, ein oder mehrere durch jeweils
einen BFL-Logik-Zweig und einen nachfolgenden BFL-Buffer-
Zweig gebildete BFL-Verknüpfungsglieder aufweisenden
GaAs-MESFET-Logik-Schaltung (BFL) mit einer in SDFL-
Technik realisierten GaAs-MESFET-Logik-Schaltung
(SDFL) dem durch den Ausgang des Buffer-Zweigs (B)
eines BFL-Verknüpfungsgliedes gebildeten Ausgang (bfl)
der übrigen BFL-Logik-Schaltung (BFL) ein BFL-Logik-Zweig
(I) nachgeschaltet ist, dessen Ausgang direkt mit dem
Eingang (sdfl) eines SDFL-Verknüpfungsgliedes (II) verbunden ist, das dem Eingang der übrigen SDFL-Logik-
Schaltung (SDFL) vorgeschaltet ist.

2. Logik-Schaltungsanordnung nach Anspruch 1, dadurch
gekennzeichnet, daß dem Ausgang (bfl) der übrigen
BFL-Logik-Schaltung (BFL) ein BFL-Negator-Zweig (I)
nachgeschaltet ist, dessen Ausgang direkt mit dem
Eingang (sdlf) eines SDLF-Negators (II) verbunden ist,
der dem Eingang der übrigen SDLF-Logik-Schaltung (SDLF)
vorgeschaltet ist.

3. Logik-Schaltungsanordnung nach Anspruch 2, dadurch
gekennzeichnet, daß der SDFL-Negator durch einen Eingangszweig eines SDFL-Verknüpfungsgliedes für mehr als eine
Eingangsvariable gebildet ist.

1/1

FIG 1

FIG 2

FIG 3

Europäisches
Patentamt

**EUROPÄISCHER RECHERCHENBERICHT**

0131951

Nummer der Anmeldung

EP 84 10 8361

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| A | IEE PROCEEDINGS, Band 127, Nr. 5, Oktober 1980, Seiten 297-300, Stevenage, Herts., GB; A.W. LIVINGSTONE u.a.: "Capacitor coupling of GaAs defletion-mode f.e.t.s." <br> * Figur 7; Seite 300, rechte Spalte, Zeilen 12-31 * | 1 | H 03 K 19/094 |

-----

RECHERCHIERTE
SACHGEBIETE (Int. Cl. 3)

H 03 K

Der vorliegende Recherchenbericht wurde für alle Patentansprüche erstellt.

| Recherchenort | Abschlußdatum der Recherche | Prüfer |
|---|---|---|
| DEN HAAG | 01-10-1984 | FEUER F.S. |